(19) Europäisches Patentamt

European Patent Office

Office européen des brevets

(11) **EP 0 614 268 B1**

(12) **EUROPEAN PATENT SPECIFICATION**

(45) Date of publication and mention
of the grant of the patent:
**16.12.1998 Bulletin 1998/51**

(51) Int Cl.⁶: **H03D 7/00**, H04L 27/22

(21) Application number: **94301331.8**

(22) Date of filing: **24.02.1994**

(54) **Method and apparatus for producing a difference signal between signal frequencies, and for detection of modulation**

Verfahren und Gerät zum Generieren eines Differenzsignals zwischen Signalfrequenzen und zur Modulationsdetektion

Procédé et appareil pour produire un signal de différence entre fréquences de signal et pour la détection de modulation

(84) Designated Contracting States:
**DE FR GB SE**

(30) Priority: **04.03.1993 FI 930973**

(43) Date of publication of application:
**07.09.1994 Bulletin 1994/36**

(73) Proprietor: **NOKIA MOBILE PHONES LTD.**
**02150 Espoo (FI)**

(72) Inventors:
- **Rapeli, Juha**
  **SF-90570 Oulu (FI)**

- **Kananen, Kari**
  **Sf-90570 Oulu (FI)**

(74) Representative: **Lind, Robert**
**Nokia Mobile Phones Ltd.,**
**Patent Department,**
**P.O. Box 100**
**00045 Nokia Group (FI)**

(56) References cited:
**DE-A- 3 130 177**      **FR-A- 2 451 661**

- **PATENT ABSTRACTS OF JAPAN vol. 12, no. 500 (E-699) 27 December 1988 & JP-A-63 211 915 (FUJITSU TEN LTD)**

## Description

The present invention relates to a method and apparatus for down converting a modulated high-frequency signal to a lower frequency using a mixer, and detecting the modulation.

In order to detect a modulated signal, the frequency of a carrier wave forming a received signal in a radio apparatus, such as in a radio phone, is reduced by one or two mixing phases such that it is sufficiently low for the frequency or phase deviation used in the modulation to be within the frequency or phase resolution range of the detector. For instance, in the commonly known QPSK modulation (Quadrature Phase Shift Keying), a 90 degree phase shift implies only a 250 pico second time difference in about 1 GHz frequency signal in the waveform of the signal but when mixed, for 1 MHz frequency, the equivalent time difference is already 250 nanoseconds. The latter time difference can easily be measured.

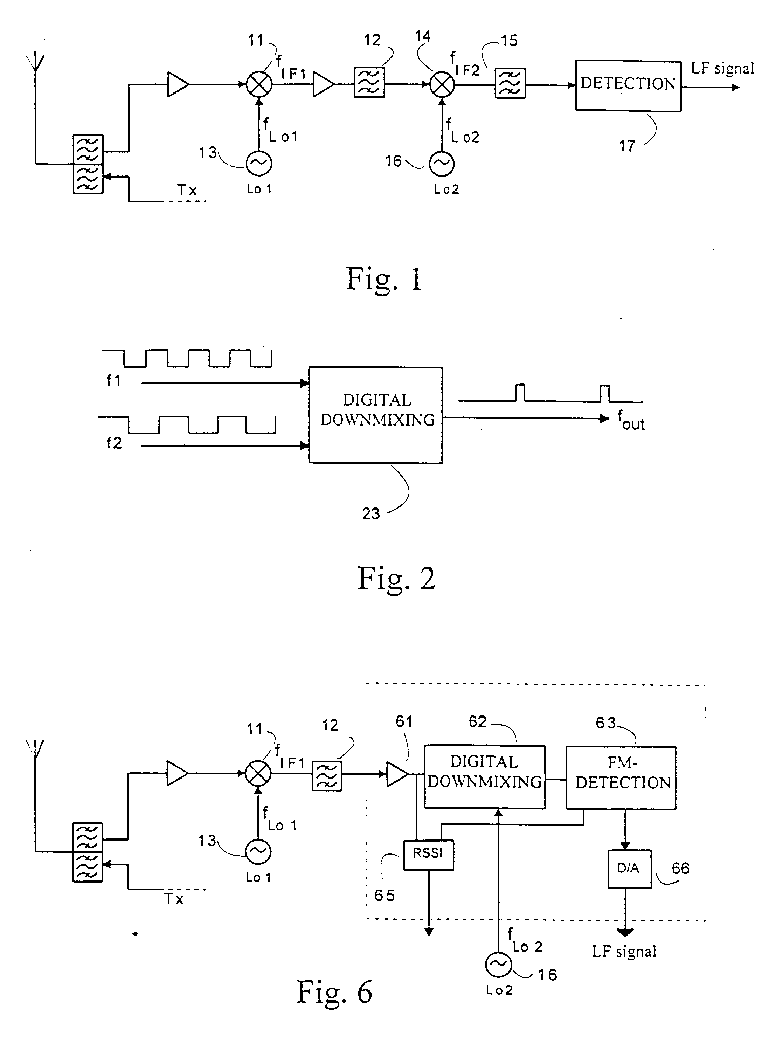

Fig. 1 presents a conventional procedure for reducing the frequency of a received radio frequency signal. The received signal $f_{RX}$ is carried through an antenna filter, a duplex filter when in a radio phone, and an amplifier to a multiplier 11. Analog multiplication of the carrier wave is carried out therein with a fixed mixing frequency $f_{LO1}$ obtained from a local oscillator LO1, and from among the mixing results thus obtained a desired intermediate frequency $f_{IF1} = f_{LO1} - f_{RX}$ is selected with a frequency domain filter 12. As regards the detection, it would be preferable to select the intermediate frequency $f_{IF1}$ to be small enough, but in radio apparatus currently used this cannot be done. The reason is that the input signal generally contains also such frequencies with which the other difference frequencies $f_{RX} - f_{LO}$ produced in the multiplier would pass onto the critical frequency $f_{IF1}$ of the filter and would generate spurious response.

As an example thereof a radio phone with 935 to 970 MHz reception frequency range may be mentioned. The intermediate frequency $f_{IF1}$ should be higher than the input frequency range divided by two, that is 35 MHz/2, because otherwise in the reception, in the lower end of the reception frequency range and at 15 MHz intermediate frequency, and at 950 MHz local oscillator frequency $f_{LO}$, the apparatus would receive two outputs of different frequencies, that is, the desired $f_{RX} = 935$ MHz, in which the following is valid:

$$f_{LO} - f_{RX} = 950 \text{ MHz} - 935 \text{ MHz} = 15 \text{ MHz}$$

and a non-desired so-called mirror frequency $f_{RX} = 965$ MHz, in which the following is valid:

$$f_{RX} - f_{LO} = 965 \text{ MHz} - 950 \text{ MHz} = 15 \text{ MHz}.$$

The elimination of a mirror-frequency reception therefore pre-requires that $f_{IF1}$ is in the upper half of the received frequency range. Moreover, when endeavours are made to keep $f_{LO}$ outside the RX band, in order to prevent the $f_{LO}$ from being connected to the antenna, it follows that $f_{IF1}$ must be greater than the RX band, i.e. it should be typically 35-100 MHz. This is still a far too high a frequency for implementing the detection, and for that purpose, the frequency is again reduced. The entire selectivity required of a receiver is implemented with $f_{IF1}$, so that almost the only objective of the second mixing is the reduction of the frequency to be detected.

A method of shifting a signal to another intermediate frequency known in the art is also shown in Figure. 1. Therein, a first intermediate signal $f_{IF1}$ and a second local oscillator signal $f_{LO2}$ received from a second local oscillator LO2 are multiplied in multiplier 14, and the desired mixing result $f_{IF2}$ is selected with filter 15 of the frequency domain. In block 17, the detection of the modulation is illustrated with a quadrature detector known in the art

The greatest drawback of the design known in the art is the filter required after the multiplier, which using the prior art techniques cannot be integrated on one and same silicon chip, for instance together with the multiplier and the detector. The second drawback is the continuous power consumption of the linear multiplier.

Patents Abstracts of Japan, vol. 12, no. 500 (E-699), describes a circuit for generating a difference frequency signal between a pair of input signals, one of the input signals being modulated and the other being unmodulated. The modulated input signal is applied to the input (D) of a D-type flip-flop whilst the unmodulated input signal is applied to the clock input (CK) of the flip-flop. The output signal (Q) of the flip-flop provides the difference signal. FR-A-2451661 and DE-A-3130177 describe similar difference frequency generating circuits.

According to a first aspect of the present invention there is provided a method for producing a frequency difference signal between a modulated signal ($f_1$) and an unmodulated signal ($f_2$) and for detecting the modulation from the frequency difference signal, the method comprising the step of monitoring the time-related order of arrival of the front edges of the pulses of the modulated and unmodulated signal, characterised by the steps of:

generating a front edge of a frequency difference signal pulse at the same point in time as the front edge of a modulated signal pulse at which the time-related order of arrival of the pulse edges of the modulated signal ($f_1$) and the unmodulated signal ($f_2$) are found to change, whereby the frequency or phase shift of the modulated signal is detectable as a corresponding change in the frequency difference signal, and;

detecting the modulation of the frequency difference signal on the basis of the locations of the pulse edges of the frequency difference signal.

According to a second aspect of the present invention there is provided a circuit for downmixing a modulated signal and for detecting information conveyed by the modulation, the circuit having:

a first input for receiving a frequency or phase modulated first high-frequency signal ($f_1$);
a second input for receiving a second high-frequency signal ($f_2$), this second signal being unmodulated;
an output whereat a modulation information containing difference signal ($f_{OUT}$) of said frequencies is provided;
means for observing the time-related order of arrival of the front edges of the pulses of the first and a second high-frequency signals and for providing a pulse front edge to the difference signal whenever the order of arrival of the front edges of said input signal pulses changes,

characterised by means for synchronising the front edge of a pulse of the difference signal with the front edge of a pulse of a first high-frequency signal.

Embodiments of the present invention have the advantage that the coupling arrangement can be fabricated on a single semiconductor chip. Furthermore, direct detection of the modulating signal is possible at the same time as performing the down converting.

The number of pulses contained in the higher input frequency input signal, between the pulses of the output difference frequency signal, is greater by one compared with the number N of pulses contained in the lower frequency input signal. In such instance, the following holds true:

$$\frac{N}{f_2} = \frac{N+1}{f_1} \qquad (1)$$

deriving wherefrom:

$$N = \frac{f_2}{f_1 - f_2} \qquad (1a)$$

thus resulting in an output $f_{out}$ as follows:

$$f_{out} = \frac{f_2}{N} = f_1 - f_2. \qquad (1b)$$

The selection of the output signal is so accomplished that the front edges of the pulses become synchronized to conform to the modulation containing signal. The above formulae are valid when no frequency or phase shift takes place in the input frequencies.

When in a second input signal a phase or frequency change takes place because of the modulation, the change is observable also in a low-frequency output signal $f_{out}$, from which it can be detected. Let us assume that at a point of time $t = 0$ a signal $f_1$ has been modulated using a phase shift by moving the phase onwards by a phase length $\alpha$. The new location of the edge is obtained by solving the following inequality.

$$\frac{N}{f_2} > \frac{N + 1 + \alpha}{f_1} \qquad (2)$$

From this inequality a changed value N is solved, whereafter the entry order of the pulse edges of the input signals changes:

$$N > (1 + \alpha) \frac{f_2}{f_1 - f_2} \qquad (3)$$

Respectively, after a modulation incident the edge of an output pulse will be at a point of time

$$t_1 = \frac{(1 + \alpha)}{f_1 - f_2} \qquad (4)$$

It is found that the relative phase shift of the output signal as pulse lengths is still $\alpha$. Since the frequency of the output signal is low, said temporal duration of the relative phase shift is sufficient to be detected.

In practice, the value N is a digital downmixing based on pulse selection is, however, a positive integer, so that respectively, the time shift of the mixing result to a relative phase shift of the input frequency of the order of $\alpha$ is

$$\Delta T = \frac{INT \{N(\alpha)\} - INT \{N(O)\}}{f_1} + \frac{\alpha}{f_1} \qquad (5)$$

where INT {N(x) is the solution of equality (3) reduced to an integer. The greater the numbers N($\alpha$) and N(0), the smaller are the errors caused by rounding into an integer.

The invention is described below, by way of example, with reference to the accompanying drawings, in which:

Fig. 1        is the prior art block diagram of a receiver,

Fig. 2        presents a reduced principle figure of the frequency downmixing,

Fig. 3A and 3B        present pulse diagrams of the frequency downmixing,

Fig. 4A        is a circuit diagram of a design implementing the invention, and

Fig. 4B shows the pulse diagram of the design,

Fig. 5A presents an implementation of the invention, and

Fig. 5B shows the pulse diagram thereof, and

Fig. 6 is the block diagram of a FM receiver utilizing the invention.

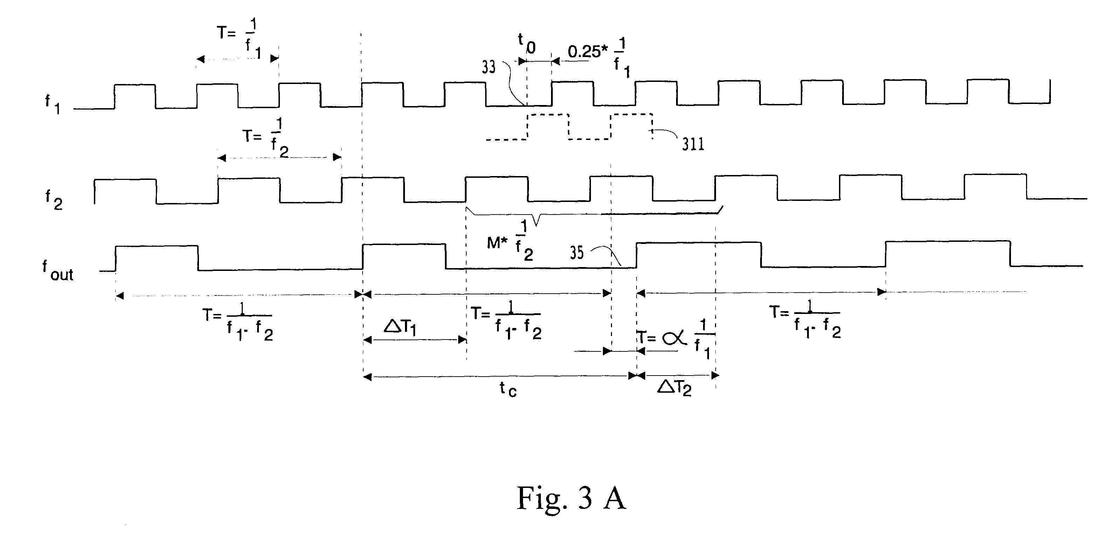

Fig. 2 presents in highly reduced form the basic idea of the invention. The frequencies of the input signals entering the inputs 21 and 22 of a digital downmixer 23 are $f_1$ and $f_2$. It is assumed that $f_1 = 45$ MHz and $f_2 = 44.55$ MHz. The information contained therein is located in a location of the edges of the pulse, to be more precise, in the changes of the front edges thereof. The downmixer 23, a design thereof being described more in detail below, produces a pulse obtained from the output 24 to the output signal $f_{out}$ whenever the order of arrival of the information containing edges 221 and 222 of the input signals $f_1$ and $f_2$ to the downmixer 23 changes. This is presented in the pulse diagram of Fig. 3A, where topmost is located the pulse diagram of the modulation containing signal $f_1$, in the middle an unmodulated frequency $f_2$ with a fixed frequency (local oscillator), and lowermost the output frequency $f_{out}$ of the downmixer. Thus, during the period between the pulses of the output signal $f_{out}$ the number of the sequences of a higher input frequency, frequency $f_1$ in Fig. 3A, is greater by one than the number N of the sequences of the lower frequency $f_2$. In such case, said formula (1) mentioned above is valid, and from formula (la) for the number of sequences, N = 99 is obtained, and from formula (lb) for the output frequency of the downmixer, $f_{out} = 450$ kHz is obtained. In a manner typical of the downmixer 23 the selection of the output signal is accomplished so that the front edges of the pulses thereof become synchronized according to the modulation containing signal $f_1$. The location of the rear edges bear no significance.

At a point of time $t_0$ the signal $f_1$ is modulated by a 90 degree phase shift, i.e. the phase is shifted onwards by a length of 0.25 sequence, Fig. 3A. In the instance of the unmodulated signal, the output signal, after the point of time $t_0$, would have a subsequent edge after 99 sequences, as described above. In the instance of the modulated signal the location of the edge changes and the new location of the edge is provided as solution from the inequality (2) as presented above:

$$\frac{N}{f_2} > \frac{N + 1 + \alpha}{f_1}$$

The order of entry of the pulse edges changes again when N pieces of $f_2$ pulses have passed, i.e. the following condition of formula (3) is valid for N:

$$N > (1 + \alpha) \frac{{}^* f_2}{f_1 - f_2} = 1.25 * 99 = 123.75$$

Respectively, the edge of a first output pulse after the modulation incident enters according to formula (4) at a point of time

$$t_1 = \frac{(1 + \alpha)}{f_1 - f_2} = 2.77 \text{ microseconds.}$$

The phase modulation in signal $f_1$ thus results in the output signal a relative phase shift of equal size in the form of sequence lengths, that is, 0.25 in the present instance.

As stated above, the relative phase shift located in the input frequency shifts directly, to form a relative phase shift of equal magnitude, into the mixing result. In practice, in digital downmixing based on pulse selection, the number N is, however, a positive integer, respectively, the time shift of the mixing result for a relative phase shift of input frequency of the order of $\alpha$ is

$$\Delta T = \frac{INT\{N(\alpha)\} - INT\{N(0)\}}{f_1} + \frac{\alpha}{f_1}$$

where INT $\{N(x)\}$ refers to the solution of formula (3) reduced into an integer. The greater the numbers $N(\alpha)$ and $N(0)$ are, the smaller are the errors due to the rounding into an integer.

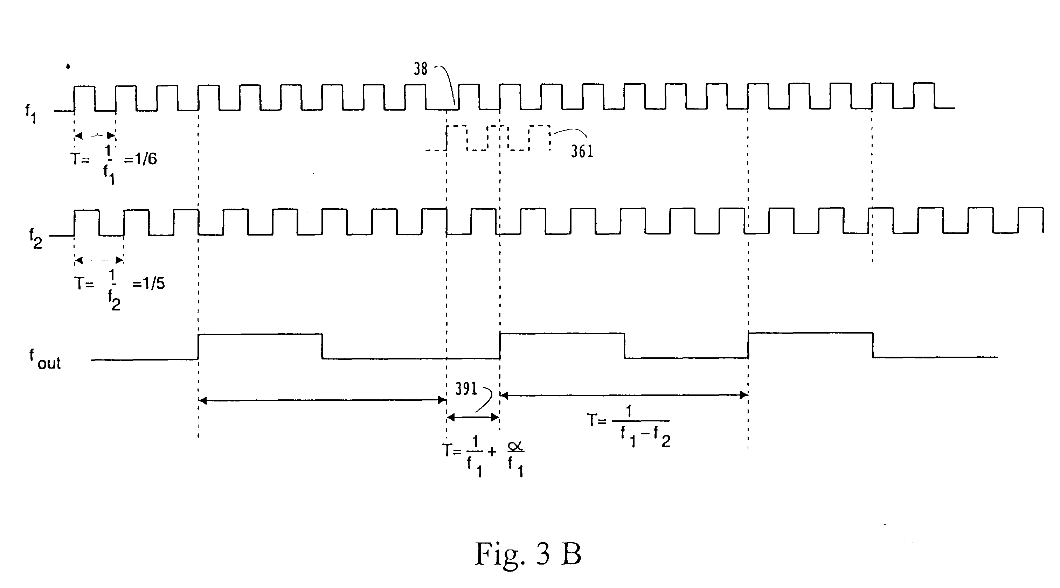

Next, reference is made to Figures 3A and 3B, on the basis whereof the production and significance of the rounding error are described. The relative frequency $f_1$ of the modulated input signal is 3 and the relative frequency $f_2$ of the unmodulated mixing signal is 2. The magnitude of the phase modulation 33 of $f_1$ taking place at a point of time $t_0$ is, according to what is stated above, 0.25 sequence lengths, that is 90 degrees, thus $\alpha = 0.25$. The broken line 311 shows, as a demonstration, part of the input signal $f_1$ in a case that no modulation would had taken place. At said numeric values according to formula (3) $N(\alpha) = 2.5$ and $N(0) = 2$, i.e. in a downmixing based on pulse selection, only the latter term thereof $\alpha/f_1$, that is, the original time-related delay of the input signal pulse edge is visible according to formula (5) as a relative phase delay of the output signal. In the output signal $f_{out}$ (lowermost signal) of Fig. 3a the delay 35 of the pulse edge caused by modulation is precisely of the size of that calculated above.

Fig. 3b presents a case in which the relative frequencies of the input signals have been raised to values $f_1 = 6$ and $f_2 = 5$, whereby the difference frequency is still 1. The size $\alpha$ of the modulating phase step is here also 0.25 of the sequence length as the reference numeral 38 refers. The broken line represents the input signal $f_1$ in an instance in which no phase modulation had taken place. At said numeric values $N(\alpha) = 6.25$ and $N(0) = 5$, when the pulse edge of the output signal $f_{out}$ shifts according to formula (5), continuing because of the modulation by the time

$$\Delta T = \frac{1}{f_1} + \frac{\alpha}{f_1}$$

i.e. by 1.25 of the sequence length of $f_1$, which can be seen as time interval 391 in Fig. 3B.

On the basis of the above description related to the rounding error it is obvious that the phase and frequency separation capacity of the downmixing method is limited and that the essential source of errors, as regards the method, is the detection of the pulse edge by means of the whole sequences either too early or too late. On the other hand, when the modulation is narrow-banded, the frequencies $f_1$ and $f_2$ can be so selected that the defective or missing pulse edges can be localized and either rejected or corrected afterwards, for instance so that the point of time of the pulse edges in a desired time window is stored in the memory. As is described below, when the intermediate frequency of an analog radio phone 45 MHz is mixed to 450 kHz frequency with the aid of 44.55 MHz mixing frequency, it is found that the correct pulse edge is located later by the sequence length 97 to 100 of $f_2$ frequency than the preceding measured edge. Using the modern time interval measurement technique, such a circuit can be implemented which detects the pulse edge of the input frequency $f_1$, the distance wherefrom to the pulse edge of the $f_2$ has been at smallest, using which method a value rounded to the nearest integer is obtained up to numeral INT $\{N(\alpha)\}$ - INT $\{N(0)\}$.

The sequence length of an output signal produced as a result of the downmixing can be measured in conjunction with the downmixing illustrated for the detection by measuring the relative location of the pulse edges of the output signal with respect to the pulse edges of a fixed mixing frequency $f_2$. Reference is still made to Fig. 3A. At the modulation, the interval of an output signal pulse lengthens, its sequence length $t_c$ being then

$$t_c = M * \frac{1}{f_2} + \Delta T_1 - \Delta T_2$$

where $\Delta T_1$ is the distance of the front edge of the detected output pulse from the edge of a subsequent $f_2$ and $\Delta T_2$ the distance of a subsequent output pulse from the edge of $f_2$ thereafter, and M refers to the number of the whole sequences remaining between said edges of $f_2$. Thus, $\Delta T_1$ is the time interval of the pulse edges of $f_1$ and $f_2$ when the pulses reach each other again. The measurement method of said short periods is known in the art and one of the methods for measuring $\Delta T_1$ and $\Delta T_2$ is disclosed in patent application FI-896267.

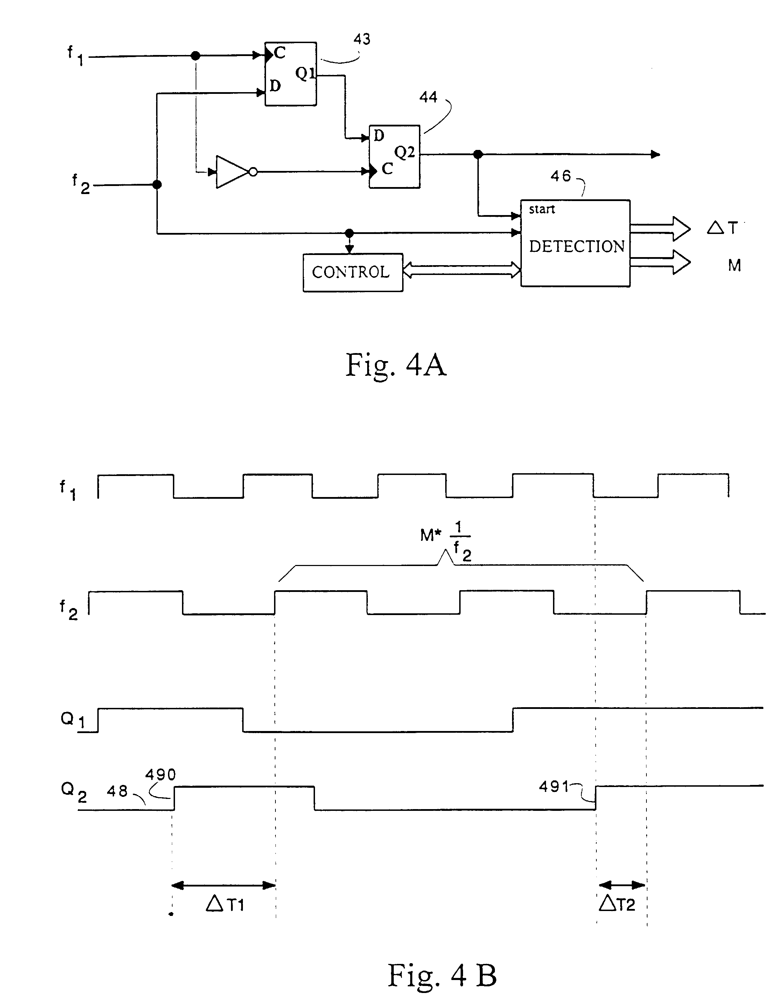

The downmixing using digital pulse selection according to the invention can be accomplished advantageously by means of a coupling including logical gates as those shown in Fig. 4A. The pulse diagram of the coupling is presented in Fig. 4B. From an unmodulated input signal $f_2$ conducted to data input D samples are taken by means of D flip-flop 43 controlled by a modulated input signal 42 carried to the clock input, whereby the output of the D flip-flop shifts its state every time at the pulse edge of a modulated signal. Hereby, the ascending edge of a pulse is shown in the output whenever the front edge of the signal reaches the clock signal.

A known drawback of the coupling is only the growth of the delay of the D flip-flop 43 when the ascending edges of the clock and data inputs approach to a distance of only pico-seconds from each other. In order to eliminate said timing uncertainty, the output is triggered on the decaying edge of $f_1$ by one half sequence length later with another D flip-flop 44. The coupling is reliable in operation even if the input signals were highly asymmetric.

If one wants to measure the time intervals $\Delta T_1$ and $\Delta T_2$ for an detection, it is accomplished with interpolator 46 so that the ascending edge 490 of the output signal, presented in Fig. 4B by line 48, starts the interpolator 46 by calculating the fractions of the sequence length and the subsequent ascending edge of frequency $f_2$ stops it, whereafter the interpolator starts the calculation of the whole pulses of the control part 47, permitted by $f_2$, until a subsequent acceptable pulse edge 491 of difference frequency enters the interpolator and starts the measurement of fraction $\Delta T_2$ of the sequence length and discontinuing the counting of the number N of the whole pulses. Said interpolator is known in the art, and one such is described in patent application FI-896267.

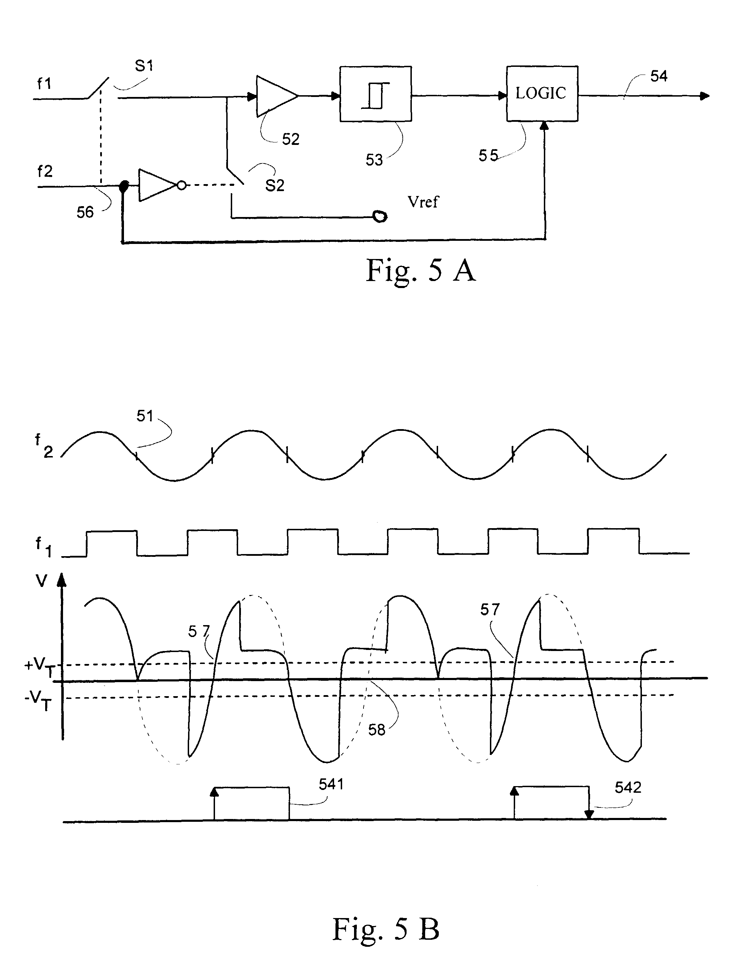

Fig. 5A presents a second embodiment of the downmixer, and Fig. 5B the pulse diagram thereof. Since the unmodulated mixing frequency $f_2$ is already of logical level in the form of point frequency, it is preferable to use a solution reverse in embodiment, in which the sampling is controlled with the aid of an unmodulated mixing frequency and in which the location of the pulse edge is determined by the amplification of the amplifier chain 52 and by the level of comparison of comparator 53. A relative change of location of the edge of the output signal 54 compared with a preceding one is determined by a change in the edge of the modulated input signal 51 because during the interval between the pulses 541, 542, the amplification of the amplifier chain 52, the amplitude of the modulated input signal 51 and the level of comparison of the comparator remain constant. The amplifier 52 may also be an integrator or a derivator, or an amplifier controlled automatically according to the level (e.g. AGC amplifier). The function of the logical block 55 is to select the signal for the output signal from each sampling interval in which a change either in a positive or negative direction occurs first.

The coupling of Figure. 5A functions so that the ascending edge of the output signal 54 is conceivable only when a signal entering the comparator exceeds the triggering threshold of the comparator in the course of the positive sequence of the clock signal $f_2$, in Figure. 5B illustrated by points 57. An equivalent exceeding of the triggering threshold during the negative edge of the clock signal $f_2$, point 58, is blocked by means of logical operations and by placing $v_{ref}$ for the level of the input signal, this being higher in voltage than the threshold level $+V_T$ required by the mode shift of the comparator. Thus, the level of the desired signal need not be amplified into a continuous, logical level pulse sequence, instead, only the local frequency $f_2$ and the output pulse 54 of the circuit would be of logical level. By this aspect, the power consumption of the circuit shown in Fig. 5A and radio frequency interferences caused by logical level signals are reduced to be as small as possible.

With the coupling of the invention, a remarkable saving can be achieved in the power consumption of a radio frequency device. Since in the radio systems, the greatest frequency deviation of the frequency modulation and in the phase modulations, the greatest phase shift speed are quantities known in the art, the operation of the downmixer can after each change in the state be discontinued for so long that the entry of a new change of state, that is, of an information containing edge of the output signal is again potential. Therefore, the active operating time of the mixer can be made short in duration and the power consumption reduced to a fraction of the power consumption of a continuous-operating mixer.

This may be demonstrated with an example. Let us assume that the signal frequency $f_1 = 45$ MHz, mixing frequency $f_2 = 44.55$ MHz and the greatest bandwidth of frequency modulation $\pm 4$ kHz. For a deviation corresponding to the extreme case of the modulation the time $t_e$ for the earliest possible point of time can be calculated in the course of which $f_2$ has propagated by n sequence length, that is,

$$t_e = \frac{n}{f_2} < \frac{n+1}{f_1}$$

from which yielded

$$n = \frac{f_2}{f_1 - f_2}$$

and

$$t_e = \frac{1}{f_1 - f_2 max}$$

For the numeric value, $t_e = 2.18$ µs, or 97 pcs of $f_2$ frequency pulses are obtained. During said 97 pulses, it is often more preferable to keep logical level calculators operating at $f_2$ frequency in operation than the pulse processing designs amplifying and comparing the modulated signal, the power consumption whereof being much greater than the logic operating at the same frequency.

The downmixing of the present invention leads to an FM/PM receiver structure advantageous with a view of the filtering of the frequency domain, and employing only one intermediate frequency, shown in Fig. 6. Therein a first intermediate frequency $f_{IF1}$ is produced similarly as in Fig. 1, but thereafter the signal with $f_{IF1}$ frequency is amplified with an amplifier 61 for making feasible the logical level signal processing, the digital downmixing according to the principle described in the foregoing is carried out in means 62 and combined therewith, the detection of FM or PM modulation in detector 63 based on pulse time interval measurement. In addition, with the operations of the circuit defined by broken line 64 an detection 65 of the strength of the entering signal has been added and conversion of the modulation detected in digital form into analog voltage by an analog / digital converter 66. The comparison of Figs 1 and 2 shows clearly the advantages achieved with the invention.

Owing to the non-ideality and digitality of the method and the circuits, the main source of errors is the timing of the pulse edge of the output signal occurring earlier or later by the amount of one or more whole sequences than what the proper location would be. It is possible to show that this is equivalent to the natural noisiness of the signal and that the signal noise ratio of the detected signal deteriorates for that reason only insignificantly.

The downmixing principle described above is, in fact, equivalent to the downmixing based on analog multiplication, only with the difference, that selecting a right output signal is carried out by selection in time level and not by filtering the frequency domain as in using an analog multiplier. The design according to the method described above is simple to carry out in the form of an integrated circuit and is therefore non-costly. The only drawback of the method is that the frequency band of the input signals must be limited.

The method can be advantageously used for instance to detect the digital modulation in the radio phone system or in the coaxial cable system so that the downmixing is carried out based on pulse selection, and the actual detection based on the measurement of the time interval of the pulses obtained as a result. The invention is particularly advantageous to carry out using a logic in which the signal levels are very low.

The above description has been drawn using the radiophone as an example and as an application.

**Claims**

1. A method for producing a frequency difference signal between a modulated signal ($f_1$) and an unmodulated signal ($f_2$) and for detecting the modulation from the frequency difference signal, the method comprising the step of monitoring the time-related order of arrival of the front edges of the pulses of the modulated and unmodulated signal, characterised by the steps of:

generating a front edge of a frequency difference signal pulse at the same point in time as the front edge of a modulated signal pulse at which the time-related order of arrival of the pulse edges of the modulated signal $(f_1)$ and the unmodulated signal $(f_2)$ are found to change, whereby the frequency or phase shift of the modulated signal is detectable as a corresponding change in the frequency difference signal, and;

detecting the modulation of the frequency difference signal on the basis of the locations of the pulse edges of the frequency difference signal.

2. A method according to claim 1, wherein the frequency difference signal is produced by taking samples controlled by the modulated signal $(f_1)$ from an unmodulated frequency $(f_2)$ and by selecting a first sample with a reversed sign for the output.

3. A method according to claim 1 or 2, wherein, for the front pulse edge of the frequency difference signal, the front pulse edge of the modulated input signal $(f_1)$ is selected which is time-wise closest to the respective front edge of an unmodulated signal $(f_2)$.

4. A method according to any one of the preceding claims, wherein, the sequence length of the frequency difference signal changes, the relative location of the pulse edges of the frequency difference signal is measured in respect with the pulse edges of an unmodulated signal $(f_2)$ and the sequence length $(t_c)$ is calculated using the following formula:

$$t_c = M * \frac{1}{f_2} + \Delta T_1 - \Delta T_2$$

where $\Delta T_1$ refers to the distance of the front edge of the detected output pulse from the subsequent pulse edge of an unmodulated signal $f_2$, $\Delta T_2$ refers to the distance of a subsequent detected output pulse from the pulse edge of an unmodulated signal $(f_2)$ following thereafter, and M refers to the number of the whole sequences of the unmodulated signal remaining between said pulse edges.

5. A circuit for downmixing a modulated signal and for detecting information conveyed by the modulation, the circuit having:

a first input for receiving a frequency or phase modulated first high-frequency signal $(f_1)$;
a second input for receiving a second high-frequency signal $(f_2)$, this second signal being unmodulated;
an output whereat a modulation information containing difference signal $(f_{OUT})$ of said frequencies is provided;
means for observing the time-related order of arrival of the front edges of the pulses of the first and a second high-frequency signals and for providing a pulse front edge to the difference signal whenever the order of arrival of the front edges of said input signal pulses changes,

characterised by means for synchronising the front edge of a pulse of the difference signal with the front edge of a pulse of a first high-frequency signal.

6. A circuit according to claim 5, wherein the means for observing and providing and for syncronizing consist of a D-type flip-flop (43), to the clock input of which is provided the first high-frequency signal $(f_1)$ and to the data input of which is provided the second high-frequency signal $(f_2)$, and from the output of which is provided said difference signal.

7. A circuit according to claim 6 and comprising a second D-type flip-flop (44), the clock input of which is operatively connected to said first input of the circuit with the data input of the second D-type flip-flop being connected to the output of the first D-type flip-flop (43), and the output from the second D-type flip-flop providing a second difference signal.

8. A circuit according to claim 7, characterized in that the circuit comprises an interpolar (46) counting the fractions of the sequence length, the inputs of the interpolator comprising said second difference signal and said second high-frequency signal $(f_2)$, and being arranged to calculate the time-related distance $T_1$ of the front edge of a detected output pulse from the pulse edge of a subsequent unmodulated signal $(f_2)$, the time-related distance $T_2$ of a subsequent detected output pulse from the pulse edge of a subsequent unmodulated signal $(f_2)$, and the number M of the whole sequence of the unmodulated signal remaining between said pulse edges, whereby the sequence length $t_c$ of the frequency difference signal can be calculated using the following formula:

$$t_c = M * \frac{1}{f_2} + \Delta T_1 - \Delta T_2 \, .$$

9. A circuit according to claim 5 and comprising:

a first switch (S1), amplifier means (52), a comparator (53) and logic means (55), all coupled subsequently to said first switch whereby said first signal can be connected through the first said switch (S1) to the input of the amplifier means (52), and said difference signal can be provided from the output of the logic means, and

a second switch (S2), through which the input signal ($f_1$) of the amplifier means can be connected directly to the logic means (55),

whereby the position of the first and the second switches at any moment is determined in the form of a response to said second signal ($f_2$), so that samples from the first signal are conducted to the amplifier means.

10. A circuit according to claim 9, wherein the logic means provide said difference signal with an ascending edge only when a signal entering the comparator (53) exceeds the triggering threshold of the comparator in the course of the positive sequence of the first signal ($f_1$).

11. A circuit according to any one of claims 5 to 10, wherein, with the exception of a basic clock frequency of the circuit, all activities are discontinued, starting from the detected pulse edge being at the difference frequency, for a period of time related to the bandwidth of the modulated signal, wherein after said period of time a new pulse edge at the difference frequency is probable.

**Patentansprüche**

1. Verfahren zur Erzeugung eines Frequenz-Differenzsignals zwischen einem modulierten Signal ($f_1$) und einem nicht modulierten Signal ($f_2$), und zur Detektion der Modulation aus dem Frequenz-Differenzsignal, wobei das Verfahren einen Schritt zur Überwachung der zeitliche Reihenfolge des Eintreffens von vorderen Flanken der Pulse des modulierten und des nicht modulierten Signals enthält, **gekennzeichnet durch** folgende Schritte:

   - Erzeugung einer vorderen Flanke eines Frequenz-Differenzsignalpulses zum selben Zeitpunkt wie die vordere Flanke eines modulierten Signalpulses, zu dem sich die zeitliche Reihenfolge des Eintreffens von Pulsflanken des modulierten Signals ($f_1$) und des nicht modulierten Signals ($f_2$) ändert, wobei die Frequenz- oder Phasenverschiebung des modulierten Signals als korrespondierende Änderung des Frequenzdifferenzsignals detektierbar ist; und
   - Detektion der Modulation des Frequenzdifferenzsignals basierend auf den Positionen der Pulsflanken des Frequenzdifferenzsignals.

2. Verfahren nach Anspruch 1, bei dem das Frequenzdifferenzsignal erzeugt wird, indem durch das modulierte Signal ($f_1$) gesteuerte Abtastwerte von der nicht modulierten Frequenz ($f_2$) genommen werden, und ein erster Abtastwert mit einem umgekehrten Vorzeichen für den Ausgang ausgewählt wird.

3. Verfahren nach Anspruch 1 oder 2, bei dem für die vordere Pulsflanke des Frequenzdifferenzsignals die vordere Pulsflanke des modulierten Eingangssignals ($f_1$) ausgewählt wird, die der jeweiligen vorderen Flanke des nicht modulierten Signals ($f_2$) zeitmäßig am nächsten ist.

4. Verfahren nach irgendeinem der vorangegangenen Ansprüche, bei dem sich die Folgelänge des Frequenzdifferenzsignals ändert, die relative Position der Pulsflanken des Frequenzdifferenzsignals bezüglich der Pulsflanken des nicht modulierten Signals ($f_2$) gemessen und die Folgelänge ($t_c$) durch folgende Formel berechnet wird:

$$t_c = M * (1/f_2) + \Delta T_1 - \Delta T_2;$$

wobei $\Delta T_1$ der Abstand der vorderen Flanke des detektierten Ausgangspulses von der folgenden Pulsflanke eines nicht modulierten Signals $f_2$; $\Delta T_2$ der Abstand eines folgenden detektierten Ausgangspulses von der Pulsflanke eines danach folgenden nicht modulierten Signals ($f_2$); und M die Anzahl der gesamten Folgen des nicht modulierten zwischen den Puls flanken verbleibenden Signals sind.

5. Schaltung zum Abwärtsmischen eines modulierten Signals und zur Detektion von in der Modulation enthaltener Information, wobei die Schaltung folgendes enthält:

   - einen ersten Eingang für den Empfang eines frequenz- oder phasemodulierten ersten Hochfrequenzsignals ($f_1$);
   - einen zweiten Eingang für den Empfang eines zweiten nicht modulierten-Hochfrequenzsignals ($f_2$);
   - einen Ausgang, an dem ein die Modulationsinformation enthaltendes Differenzsignal ($f_{aus}$) der Frequenzen zur Verfügung gestellt wird;
   - Mittel zum Beobachten der zeitlichen Reihenfolge des Eintreffens der vorderen Flanken der Pulse des ersten und zweiten Hochfrequenzsignals, und zum Bereitstellen einer vorderen Puls flanke für das Differenzsignal, jedesmal wenn sich die Reihenfolge des Eintreffens der vorderen Flanken der Eingangssignalpulse ändert, **gekennzeichnet durch** Mittel zur Synchronisierung der vorderen Flanke eines Pulses des Differenzsignals mit der vorderen Flanke eines Pulses des ersten Hochfrequenzsignals.

6. Schaltung nach Anspruch 5, bei dem die Mittel zum Überwachen, Bereitstellen und Synchronisieren aus einem D-Flip-Fflop (43) bestehen, an dessen Takteingang das erste Hochfrequenzsignal ($f_1$) und an dessen Dateneingang das zweite Hochfrequenzsignal ($f_2$) angelegt sind, und an dessen Ausgang das Differenzsignal zur Verfügung gestellt wird.

7. Schaltung nach Anspruch 6, mit einem zweiten D-Flip-Flop (44), dessen Takteingang wirksam mit dem ersten Eingang der Schaltung, und dessen Dateneingang mit dem Ausgang des ersten D-Flip-Flops (43) verbunden ist, und an dessen Ausgang ein zweites Differenzsignal zur Verfügung gestellt wird.

8. Schaltung nach Anspruch 7, **dadurch gekennzeichnet**, daß die Schaltung einen Interpolator (46) enthält, der die Bruchteile der Folgelänge zählt, wobei die Eingänge des Interpolators das zweite Differenzsignal und das zweite Hochfrequenzsignal ($f_2$) enthalten und vorgesehen sind, um den zeitlichen Abstand $T_1$ der vorderen Flanke eines detektierten Ausgangspulses von der Pulsflanke eines folgenden nicht modulierten Signals ($f_2$), den zeitlichen Abstand $T_2$ eines folgenden detektierten Ausgangspulses von der Pulsflanke eines folgenden nicht modulierten Signals ($f_2$), und die Zahl M der gesamten Folge des nicht modulierten zwischen den Pulsflanken verbleibenden Signals zu berechnen, wobei die Folgelänge $t_c$ des Frequenzdifferenzsignals mit folgender Formel berechnet werden kann:

$$t_c = M * (1/f_2) + \Delta T_1 - \Delta T_2;$$

9. Schaltung nach Anspruch 5, mit:

- einem ersten Schalter (S1), Verstärkermitteln (52), einem Komparator (53) und Logikmitteln (55), die der Reihe nach mit dem ersten Schalter gekoppelt sind, wobei das erste Signal durch den ersten Schalter (S1) mit dem Eingang der Verstärkermittel (52) verbunden und das Differenzsignal am Ausgang der Logikmittel zur Verfügung gestellt werden kann; und
- einem zweiten Schalter (S2), durch den das Eingangssignal ($f_1$) der Verstärkermittel direkt mit den Logikmitteln (55) verbunden werden kann, wobei die Stellung des ersten und zweiten Schalters zu jeder Zeit in Form einer Antwort auf das zweite Signal ($f_2$) bestimmt wird, so daß Abtastwerte vom ersten Signal zu den Verstärkermitteln geleitet werden.

10. Schaltung nach Anspruch 9, bei dem die Logikmittel das Differenzsignal mit einer ansteigenden Flanke nur zur Verfügung stellen, wenn ein an dem Komparator (53) anliegendes Signal den Triggerschwellenwert des Komparators im Verlauf der positiven Folge des ersten Signals ($f_1$) überschreitet.

11. Schaltung nach irgendeinem der Ansprüche 5 bis 10, bei dem mit Ausnahme einer Grundtaktfrequenz der Schaltung, alle Aktivitäten eingestellt werden, beginned mit der detektierten Pulsflanke bei der Differenzfrequenz, und zwar für eine auf die Bandbreite des modulierten Signals bezogene Zeitperiode, wobei nach dieser Zeitperiode eine neue Puls flanke bei der Differenzfrequenz wahrscheinlich ist.

## Revendications

1. Procédé pour produire un signal de différence de fréquence entre un signal modulé ($f_1$) et un signal non modulé ($f_2$) et pour détecter la modulation à partir du signal de différence de fréquence, le procédé comprenant l'étape consistant à suivre l'ordre d'arrivée dans le temps des fronts avant des impulsions du signal modulé et non modulé, caractérisé par les étapes :

de production d'un front avant d'une impulsion de signal de différence de fréquence au même instant que le front avant d'une impulsion de signal modulé pour lequel on trouve que l'ordre d'arrivée dans le temps des fronts d'impulsions du signal modulé ($f_1$) et du signal non modulé ($f_2$) varie, de sorte que le décalage de fréquence ou le déphasage du signal modulé peut être détecté sous la forme d'une variation correspondante du signal de différence de fréquence ; et

de détection de la modulation du signal de différence de fréquence sur la base des positions des fronts d'impulsions du signal de différence de fréquence.

2. Procédé selon la revendication 1, dans lequel le signal de différence de fréquence est produit en prélevant des échantillons commandés par le signal ($f_1$) modulé à partir d'une fréquence ($f_2$) non modulée et en sélectionnant un premier échantillon de signe inversé pour la sortie.

3. Procédé selon la revendication 1 ou 2, dans lequel, pour le front d'impulsion avant du signal de différence de fréquence, le front d'impulsion avant du signal ($f_1$) d'entrée modulé est sélectionné et est le plus proche dans le temps du front avant respectif d'un signal ($f_2$) non modulé.

4. Procédé selon l'une quelconque des revendications précédentes, dans lequel la longueur de séquence du signal de différence de fréquence varie, la position relative des fronts d'impulsions du signal de différence de fréquence est mesurée par rapport aux fronts d'impulsions d'un signal ($f_2$) non modulé et la longueur ($t_c$) de séquence est calculée à partir de la formule suivante :

$$t_c = M * \frac{1}{f_2} + \Delta T_1 - \Delta T_2$$

où $\Delta T_1$ désigne la distance du front avant de l'impulsion de sortie détectée au front d'impulsion suivant d'un signal $f_2$ non modulé, $\Delta T_2$ désigne la distance d'une impulsion de sortie détectée suivante au front d'impulsion d'un signal ($f_2$) non modulé venant ensuite, et M désigne le nombre de séquences entières du signal non modulé restant entre lesdits fronts d'impulsions.

5. Circuit pour mélanger-abaisser un signal modulé et pour détecter les informations contenues dans la modulation, le circuit ayant :

une première entrée pour recevoir un premier signal ($f_1$) à haute fréquence modulé en fréquence ou en phase ;
une seconde entrée pour recevoir un second signal ($f_2$) à haute fréquence, ce second signal étant non modulé ;
une sortie sur laquelle est fournie un signal ($f_{OUT}$) de différence contenant des informations de modulation desdites fréquences ;
des moyens pour observer l'ordre d'arrivée dans le temps des fronts avant des impulsions des premier et second signaux à haute fréquence et pour fournir un front avant d'impulsion au signal de différence chaque fois que l'ordre d'arrivée des fronts avant desdites impulsions de signal d'entrée varie,

caractérisé par des moyens destinés à synchroniser le front avant d'une impulsion et du signal de différence avec le front avant d'une impulsion d'un premier signal à haute fréquence.

6. Circuit selon la revendication 5, dans lequel les moyens d'observation, de fourniture et de synchronisation sont constitués d'une bascule (43) de type D à l'entrée d'horloge de laquelle est fourni le pre-

mier signal ($f_1$) à haute fréquence et à l'entrée de données de laquelle est fourni le second signal ($f_2$) à haute fréquence, et à la sortie de laquelle on obtient ledit signal de différence.

7. Circuit selon la revendication 6, comprenant une seconde bascule (44) de type D dont l'entrée d'horloge est fonctionnellement connectée à ladite première entrée du circuit, l'entrée de données de la seconde bascule de type D étant connectée à la sortie de la première bascule de type D (43), et la sortie de la seconde bascule de type D fournissant un second signal de différence.

8. Circuit selon la revendication 7, caractérisé en ce que le circuit comprend un interpolateur (46) comptant les fractions de la longueur de séquence, les entrées de l'interpolateur comprenant ledit second signal de différence et ledit second signal à haute fréquence ($f_2$), et étant agencées de façon à calculer la distance $T_1$ dans le temps du front avant d'une impulsion de sortie détectée par rapport au front d'impulsion d'un signal ($f_2$) non modulé suivant, la distance $T_2$ dans le temps d'une impulsion de sortie détectée suivante par rapport au front d'impulsion d'un signal ($f_2$) non modulé suivant, et le nombre M de séquences entières du signal non modulé restant entre lesdits fronts d'impulsions, de sorte que la longueur de séquence $t_c$ du signal de différence de fréquence peut être calculée à partir de la formule suivante :

$$t_c = M * \frac{1}{f_2} + \Delta T_1 - \Delta T_2$$

9. Circuit selon la revendication 5, comprenant :

un premier commutateur (S1), des moyens (52) amplificateurs, un comparateur (53) et des moyens (55) logiques, tous couplés en aval dudit premier commutateur, de sorte que ledit premier signal peut être connecté par l'intermédiaire dudit premier commutateur (S1) à l'entrée des moyens (52) amplificateurs, et que ledit signal de différence peut être fourni à partir de la sortie des moyens logiques, et
un second commutateur (S2) par l'intermédiaire duquel le signal d'entrée ($f_1$) des moyens amplificateurs peut être directement connecté aux moyens logiques (55),
la position des premier et second commutateurs à un instant quelconque étant déterminée sous la forme d'une réponse audit second signal ($f_2$), de sorte que des échantillons provenant du premier signal sont acheminés aux moyens amplificateurs.

**10.** Circuit selon la revendication 9, dans lequel les moyens logiques ne fournissent ledit signal de différence avec un front montant que lorsqu'un signal atteignant le comparateur (53) dépasse le seuil de déclenchement du comparateur au cours de la séquence positive du premier signal ($f_1$).

**11.** Circuit selon l'une quelconque des revendications 5 à 10, dans lequel, à l'exception d'une fréquence d'horloge de base du circuit, toutes les activités sont interrompues, à partir du moment où le front d'impulsion détecté se situe à la fréquence de différence, pendant un temps dépendant de la largeur de bande du signal modulé, et dans lequel, après ladite période de temps, un nouveau front d'impulsion est probable à la fréquence de différence.

Fig. 1

Fig. 2

Fig. 6

Fig. 3 A

EP 0 614 268 B1

Fig. 3 B

Fig. 4A

Fig. 4 B

Fig. 5 A

Fig. 5 B